(19) Europäisches Patentamt
European Patent Office
Office européen des brevets

(11) **EP 2 816 681 A1**

(12) **EUROPÄISCHE PATENTANMELDUNG**

(43) Veröffentlichungstag:
**24.12.2014 Patentblatt 2014/52**

(51) Int Cl.:
*H01S 5/14* (2006.01)     *H01S 5/10* (2006.01)
*H01S 5/40* (2006.01)

(21) Anmeldenummer: **14164759.4**

(22) Anmeldetag: **15.04.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **18.06.2013 EP 13172422**

(71) Anmelder: **PBC Lasers GmbH**
**10623 Berlin (DE)**

(72) Erfinder: **Kettler, Thorsten**
**10247 Berlin (DE)**

(74) Vertreter: **Fischer, Uwe**
**Patentanwalt**
**Moritzstraße 22**
**13597 Berlin (DE)**

(54) **Laserarray mit einem externen Resonator**

(57) Die Erfindung bezieht sich auf einen Laser (1) mit einem Laserchip (10), der eine Mehrzahl aktiver Laserkanäle (20), eine Frontfacette (10a) zur Auskopplung der Laserstrahlung der Laserkanäle (20) und eine Rückfacette (10b) zur rückseitigen Reflexion der Laserstrahlung der Laserkanäle (20) in Richtung Frontfacette (10a) aufweist, einem externen Resonator (50), der einen Teil der von dem Laserchip (10) an der Frontfacette (10a) austretenden Strahlung in den Laserchip (10) zurückkoppelt und durch die Rückkoppelung die Strahlung der Laserkanäle (20) miteinander koppelt, wobei zumindest einer der Laserkanäle (20) zumindest abschnittweise gekrümmt ist und - im Fernfeld - zusätzlich zu einer Hauptstrahlkeule (P3) von dem Laserchip (10) mindestens eine Nebenkeule (P1, P2) divergent abgestrahlt wird und wobei der Resonator (50) mindestens eine der Nebenkeulen (P1, P2), die - im Fernfeld - neben einer Hauptstrahlkeule (P3) von dem Laserchip (10) divergent abgestrahlt wird, in Richtung Laserchip (10) reflektiert.

Fig. 17

EP 2 816 681 A1

**Beschreibung**

Die Erfindung bezieht sich auf einen Laser mit einem Laserchip, der eine Mehrzahl aktiver Laserkanäle, eine Frontfacette zur Auskopplung der Laserstrahlung der Laserkanäle und eine Rückfacette zur rückseitigen Reflexion der Laserstrahlung der Laserkanäle in Richtung Frontfacette aufweist.

Halbleiterlaser mit sehr hoher optischer Ausgangsleistung werden häufig für die Materialbearbeitung eingesetzt. Um eine hohe optische Leistung im Bereich von einigen 10W bis hin zu kW zu erreichen, werden bekanntermaßen z. B. Breitstreifenlaser eingesetzt. Diese vorbekannten Laser emittieren eine breite, vielmodige Strahlkeule. Diese Strahlkeule hat eine vergleichsweise schlechte Strahlqualität, wodurch die optische Energie des Laserchips nur schlecht fokussiert werden kann. Dadurch ist bei diesen Laserchips die erreichbare Leistungsdichte in einem Fokuspunkt begrenzt.

Weiterhin ist bekannt, Laserchips zu verwenden, die viele einzelne aktive Laserkanäle auf einem Chip aufweisen. Wenn diese Laserkanäle sehr dicht nebeneinander angeordnet sind, kann die Strahlung der benachbarten Kanäle miteinander optisch durch Interferenz koppeln und es können sich wenige, spezielle optische Moden ausbilden, die zu einer Einengung der emittierten Strahlkeule führen können. Dieses ist vorteilhaft, da man die optische Energie auf einem kleineren Raum gut konzentrieren kann.

Der Erfindung liegt die Aufgabe zugrunde, einen Laser mit einer Mehrzahl aktiver Laserkanäle anzugeben, der bessere Emissionseigenschaften als vorbekannte Laser dieser Bauart aufweist.

Diese Aufgabe wird gemäß einer ersten erfindungsgemäßen Ausführungsvariante durch einen Laser mit den Merkmalen gemäß Patentanspruch 1 gelöst. Vorteilhafte Ausgestaltungen des erfindungsgemäßen Lasers sind in Unteransprüchen angegeben.

Danach ist - gemäß der ersten erfindungsgemäßen Ausführungsvariante - ein Laser vorgesehen mit einem Laserchip, der eine Mehrzahl aktiver Laserkanäle, eine Frontfacette zur Auskopplung der Laserstrahlung der Laserkanäle und eine Rückfacette zur rückseitigen Reflexion der Laserstrahlung der Laserkanäle in Richtung Frontfacette aufweist, einem externen Resonator, der einen Teil der von dem Laserchip an der Frontfacette austretenden Strahlung in den Laserchip zurückkoppelt und durch die Rückkoppelung die Strahlung der Laserkanäle miteinander koppelt, wobei zumindest einer der Laserkanäle zumindest abschnittsweise gekrümmt ist und - im Fernfeld - zusätzlich zu einer Hauptstrahlkeule von dem Laserchip mindestens eine Nebenkeule divergent abgestrahlt wird und wobei der Resonator mindestens eine der Nebenkeulen, die - im Fernfeld - neben einer Hauptstrahlkeule von dem Laserchip divergent abgestrahlt wird, in Richtung Laserchip reflektiert.

Ein wesentlicher Vorteil des erfindungsgemäßen Lasers ist darin zu sehen, dass durch das Vorsehen abschnittsweise gekrümmter Laserkanäle und die beschriebene Rückkopplung mindestens einer Nebenkeule durch den Resonator das Auskoppelverhalten an der Frontfacette des Laserchips und/oder das Koppelverhalten zwischen der Strahlung der einzelnen Laserkanäle je nach Einsatz des Lasers individuell optimiert werden kann.

Unter einer Nebenkeule wird hier eine Strahlkeule verstanden, die eine kleinere Strahlungsleistung als die Hauptstrahlkeule der Ausgangsstrahlung aufweist; die Hauptstrahlkeule weist demgemäß die größte Strahlungsleistung der abgestrahlten Strahlkeulen auf.

Als vorteilhaft wird es angesehen, wenn die Krümmung der Laserkanäle derart ausgestaltet ist, dass - ohne die Rückkopplung des externen Resonators - keine feste Phasenbeziehung zwischen benachbarten Laserkanälen auftritt und kein Mode durch chipinterne Kopplung der Laserkanäle bevorzugt wird, und der im Laserchip anschwingende Mode durch die Rückkopplung des externen Resonators bestimmt wird.

Vorzugsweise ist der Resonator derart ausgestaltet, dass er die Strahlung der Laserkanäle derart optisch koppelt, dass im Laserchip ein In-Phase-Mode anschwingt, der - im Fernfeld - die Hauptstrahlkeule und die divergent abstrahlenden Nebenkeulen aufweist.

Besonders vorteilhaft ist es, wenn sowohl durch die Krümmung des oder der Laserkanäle als auch durch die Kopplung der Laserkanäle durch den Resonator ein In-Phase-Mode mit - im Fernfeld - einer Hauptstrahlkeule und zwei neben der Hauptstrahlkeule divergent abstrahlenden Nebenkeulen gebildet wird.

Die zwei Nebenkeulen liegen bei dem In-Phase-Mode bevorzugt auf unterschiedlichen Seiten der Hauptstrahlkeule unmittelbar benachbart neben der Hauptstrahlkeule.

Die Hauptstrahlkeule wird vorzugsweise aus dem Laser ausgekoppelt.

Bezüglich des Resonators wird es als vorteilhaft angesehen, wenn durch einen oder mehrere Resonatorspiegel des Resonators zumindest eine der neben der Hauptstrahlkeule divergent abgestrahlten Nebenkeulen, vorzugsweise zwei unmittelbar benachbart neben der Hauptstrahlkeule divergent abgestrahlte Nebenkeulen, in Richtung Laserchip reflektiert werden und die Hauptstrahlkeule den oder die Resonatorspiegel reflexionsfrei passiert.

Die Laserkanäle weisen vorzugsweise voneinander abweichende Krümmungen auf.

Vorzugsweise ist durch die Krümmung des oder der Laserkanäle und die Rückkopplung des Resonators die Kopplung der Laserkanäle derart eingestellt, dass die Phasenlage der an der Frontfacette austretenden Strahlung der einzelnen Laserkanäle untereinander kleiner als 45°, vorzugsweise nahezu oder gleich Null, ist.

Gemäß einer anderen vorteilhaften Ausgestaltung ist vorgesehen, dass die Laserkanäle zumindest auch durch eine chipinterne Kopplung gekoppelt sind. Bei einer solchen Ausgestaltung ist es vorteilhaft, wenn durch die chipinterne Kopplung der Laserkanäle im Laserchip zumindest auch ein In-Phase-Mode anschwingt, der - im Fernfeld - die Hauptstrahlkeule und die divergent abstrahlenden Nebenkeulen aufweist, und der im Laserchip anschwingende Mode durch den externen Resonator gefördert wird.

Auch ist es vorteilhaft, wenn auf dem Laserchip durch die Krümmung der Laserkanäle jeweils die Winkel der Laserkanäle an der Frontfacette und der Rückfacette unterschiedlich sind und der Winkel zumindest einiger der Laserkanäle, vorzugsweise aller Laserkanäle, zur Frontfacette ungleich 90° ist.

Vorzugsweise ist auf dem Laserchip der Winkel zumindest einiger der Laserkanäle, vorzugsweise aller Laserkanäle, zur Rückfacette gleich 90°, und die Rückfacette ist vorzugsweise mit einer reflektierenden Beschichtung versehen.

Die Frontfacette des Laserchips ist bevorzugt mit einer reflektionsvermindernden Beschichtung versehen.

Teilbereiche der Laserkanäle sind vorzugsweise gekrümmt und Teilbereiche der Laserkanäle sind vorzugsweise geradlinig.

Die eingangs genannte Aufgabe der Erfindung, nämlich einen Laser mit einer Mehrzahl aktiver Laserkanäle anzugeben, der bessere Emissionseigenschaften als vorbekannte Laser dieser Bauart aufweist, wird auch durch eine zweite erfindungsgemäße Ausführungsvariante gelöst. Die zweite erfindungsgemäße Ausführungsvariante umfasst einen Laser mit einem Laserchip, der eine Mehrzahl aktiver Laserkanäle, eine Frontfacette zur Auskopplung der Laserstrahlung der Laserkanäle und eine Rückfacette zur rückseitigen Reflexion der Laserstrahlung der Laserkanäle in Richtung Frontfacette aufweist, wobei zumindest einer der Laserkanäle zumindest abschnittweise gekrümmt ist.

Ein wesentlicher Vorteil der zweiten erfindungsgemäßen Ausführungsvariante ist darin zu sehen, dass durch das Vorsehen abschnittsweise gekrümmter Laserkanäle das Auskoppelverhalten an der Frontfacette des Laserchips und/oder das Koppelverhalten zwischen der Strahlung der einzelnen Laserkanäle je nach Einsatz des Lasers individuell optimiert werden kann.

Die nachfolgend aufgeführten vorteilhaften Ausgestaltungsformen gelten sowohl für die erste als auch für die zweite erfindungsgemäße Ausführungsvariante.

Mit Blick auf die Erzeugung von Laserstrahlen besonders hoher Ausgangsleistung bei guter Strahlqualität wird es als vorteilhaft angesehen, wenn die Laserkanäle zumindest in Teilabschnitten des Laserchips optisch miteinander gekoppelt sind.

Als besonders vorteilhaft wird es angesehen, wenn durch die Krümmung des oder der Laserkanäle die Kopplung der Laserkanäle - im Vergleich zu ausschließlich geradlinigen Laserkanälen - verändert wird und die lateralen Fernfelder der an der Frontfacette austretenden Strahlmoden modifiziert sind.

Vorzugsweise ist durch die Krümmung des oder der Laserkanäle die Kopplung der Laserkanäle derart eingestellt, dass die Phasenlage der an der Frontfacette austretenden Strahlung der einzelnen Laserkanäle untereinander kleiner als 45°, vorzugsweise nahezu oder gleich Null, ist.

Gemäß einer besonders bevorzugten Ausgestaltung des Lasers ist vorgesehen, dass durch die Krümmung des oder der Laserkanäle und die Kopplung der Laserkanäle in dem oder den gekrümmten Abschnitten ein In-Phase-Mode mit - im Fernfeld - einer Hauptstrahlkeule und zwei neben der Hauptstrahlkeule divergent abstrahlenden Nebenkeulen gebildet wird.

Vorzugsweise weist der Laser einen externen Resonator auf, der einen Teil der von dem Laserchip an der Frontfacette austretenden Strahlung in den Laserchip zurückkoppelt.

Eine besonders vorteilhafte Ausgestaltung des Lasers sieht vor, dass der externe Resonator eine der Nebenkeulen oder beide Nebenkeulen des In-Phase-Modes ganz oder zum Teil zur Frontfacette des Laserchips reflektiert, die Hauptstrahlkeule den Resonator passiert und den Laser als Ausgangsstrahl verlässt und durch die Rückkopplung der Nebenkeule oder der Nebenkeulen der In-Phase-Mode im Laserchip anschwingt.

Vorzugsweise sind durch die Krümmung der Laserkanäle jeweils die Winkel der Laserkanäle an der Frontfacette und der Rückfacette unterschiedlich.

Mit Blick auf eine möglichst geringe Rückreflexion an der Frontfacette des Laserchips wird es als vorteilhaft angesehen, wenn der Winkel zumindest einiger der Laserkanäle, vorzugsweise aller Laserkanäle, zur Frontfacette ungleich 90° ist.

Vorteilhaft ist es, wenn der Winkel zumindest einiger der Laserkanäle, vorzugsweise aller Laserkanäle, zur Rückfacette gleich 90° ist und die Rückfacette mit einer reflektierenden Beschichtung versehen ist.

Die Form der aus dem Laserchip austretenden Moden lässt sich beispielsweise variieren, wenn die Laserkanäle voneinander abweichende Krümmungen aufweisen.

Alternativ kann vorgesehen sein, dass die Laserkanäle identische Krümmungen aufweisen und äquidistant verlaufen.

Auch kann vorgesehen sein, dass Teilbereiche der Laserkanäle gekrümmt und Teilbereiche der Laserkanäle geradlinig sind.

Wie bereits erwähnt, ist eine Kopplung der Laserkanäle je nach Anwendungsbereich vorteilhaft. Um eine Kopplung zu erreichen, werden die Laserkanäle bevorzugt ganz oder zumindest in Teilabschnitten des Laserchips optisch gekoppelt. Alternativ oder zusätzlich kann eine Kopplung der Strahlung außerhalb des Laserchips, beispielsweise durch einen externen Resonator erfolgen, der die Strahlung der Laserkanäle miteinander koppelt.

Die Erfindung wird nachfolgend anhand von Ausführungsbeispielen näher erläutert; dabei zeigen beispielhaft

Figur 1     ein erstes Ausführungsbeispiel für einen er-
            findungsgemäßen Laser mit einem Laser-
            chip, wobei die Figur 1 den Laserchip in ei-
            nem Querschnitt senkrecht zur Ausbrei-
            tungsrichtung der aktiven Laserkanäle des
            Laserchips zeigt,

Figur 2     den Laser gemäß Figur 1 in einer Sicht von
            oben,

Figur 3     ein anderes Ausführungsbeispiel für einen
            gekrümmten Verlauf der Laserkanäle bei
            dem Laser gemäß Figur 1,

Figur 4     ein weiteres Ausführungsbeispiel für einen
            gekrümmten Verlauf der Laserkanäle bei
            dem Laser gemäß Figur 1,

Figur 5     ein Ausführungsbeispiel für einen Laser, der
            mit einem Laserchip und einem externen Resonator ausgestattet ist,

Figur 6     beispielhaft den Verlauf der optischen Ausgangsleistung P über dem Strom I bei einem
            Laserchip mit geraden bzw. ungekrümmten
            Laserkanälen (gestrichelte Linie) und bei einem Laser mit gekrümmten Laserkanälen
            (durchgezogene Linie),

Figur 7     beispielhaft die stromabhängigen Spektren
            eines Laserchips mit gekrümmten Laserkanälen, wobei die Darstellung links in Figur 7
            einen Laser ohne externen Resonator und
            die Darstellung rechts in Figur 7 einen Laser
            mit externem Resonator darstellt und wobei
            bei beiden Darstellungen jeweils die Leistung P über der Wellenlänge λ in Nanometern und über dem Strom I in Ampere dargestellt ist,

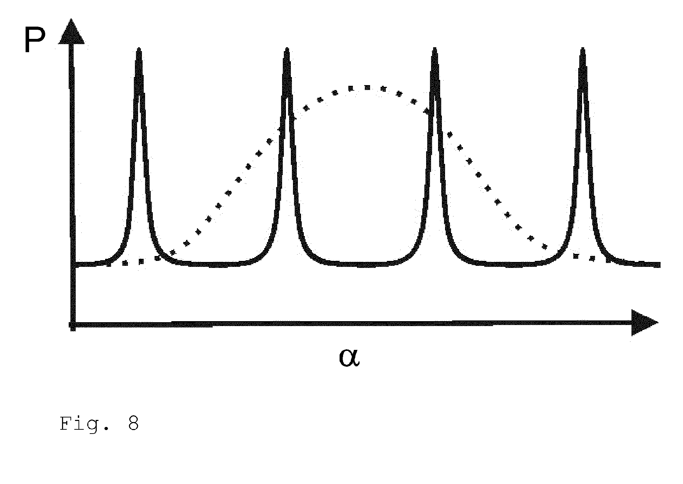

Figur 8     beispielhaft die Entstehung des Fernfeldes
            eines Modes bei gekoppelten Laserkanälen,
            wobei die durchgezogene Linie in Figur 8 die
            Position einer durch den Abstand der Kanäle
            vorgegebenen möglichen Emissionskeule
            und die gestrichelte Linie in Figur 8 die durch
            die Emission der einzelnen Laserkanäle bestimmte Intensität der Emissionskeulen
            zeigt,

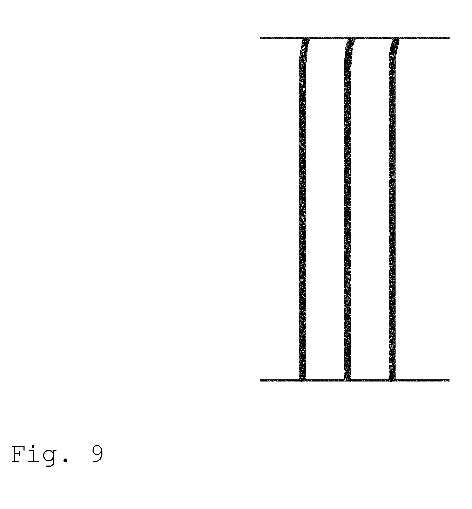

Figur 9     beispielhaft den Verlauf mehrerer Laserkanäle in einem Laserchip im Falle einer kurzen
            Krümmung der Laserkanäle in der Nähe der
            Frontfacette,

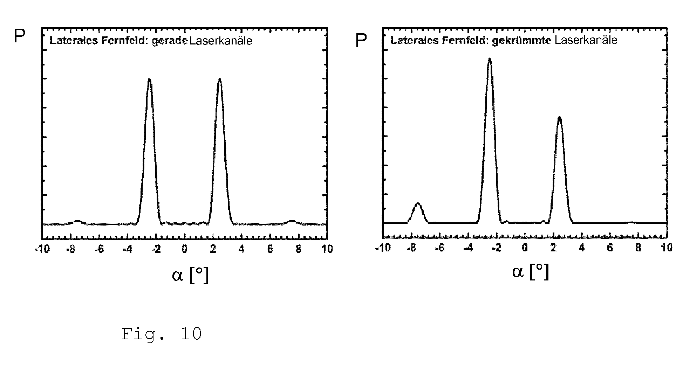

Figur 10    beispielhaft eine Modellierung des lateralen
            Fernfeldes für zwei unterschiedliche Laserchips, wobei die Darstellung links in Figur 10
            einen Laserchip mit geraden Laserkanälen
            und die Darstellung rechts in Figur 10 einen
            Laserchip mit gekrümmten Emittern zeigt
            und wobei jeweils die Intensität P über dem
            lateralen Fernfeldwinkel α dargestellt ist,

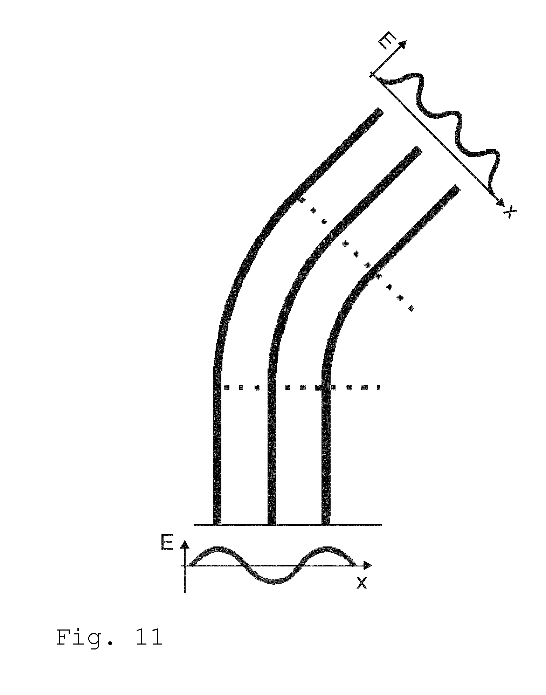

Figur 11    beispielhaft die Änderung der Phasenbeziehung zwischen benachbarten Laserkanälen

            durch unterschiedlich lange Wegstrecken
            aufgrund der Krümmung der Laserkanäle,

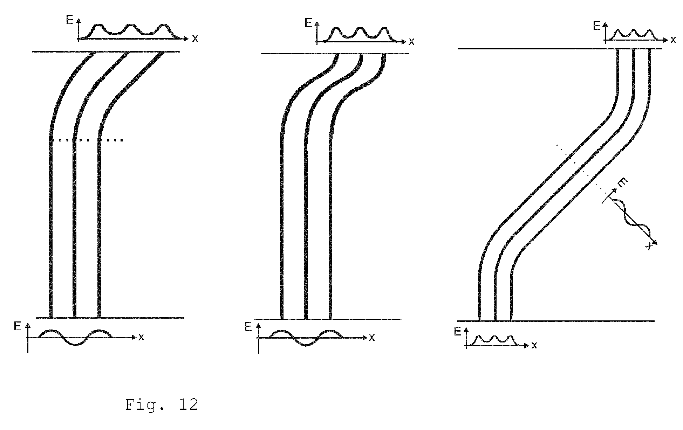

Figur 12    beispielhaft die Änderung der Phasenbeziehung zwischen benachbarten Laserkanälen
            derart, dass in der Auskoppelfacette bzw.
            Frontfacette eine Phasenbeziehung von 0°
            zwischen den benachbarten Laserkanälen
            vorliegt, während sie auf einer langen geraden Strecke im Inneren des Laserchips n beträgt, wobei die Darstellung links in der Figur
            12 die Emission unter einem zur Facettennormalen gekippten Winkel, die Darstellung
            in der Mitte in Figur 12 die Emission senkrecht zur Frontfacette durch Einführen einer
            S-Krümmung nahe der Frontfacette und die
            Darstellung rechts in Figur 12 die Emission
            senkrecht zur Frontfacette durch Einführung
            einer S-Krümmung mit mittig liegender gerader Strecke zeigt,

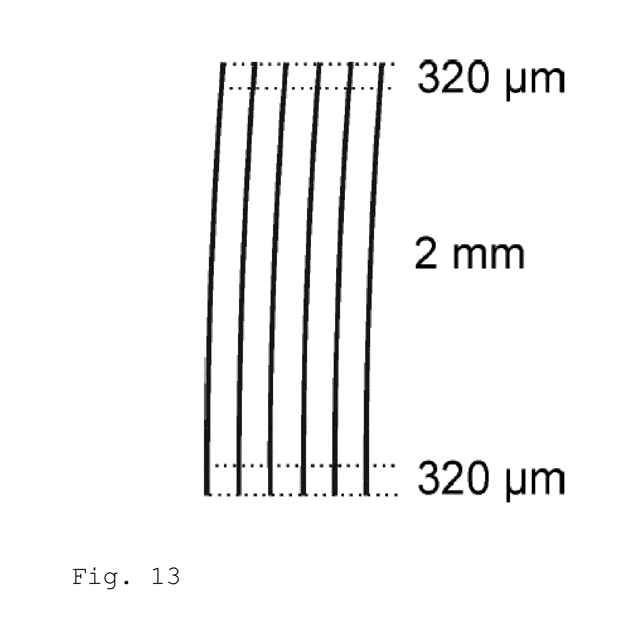

Figur 13    ein Ausführungsbeispiel für eine Form der
            Laserkanäle, bei der sich keine feste Pha-
            senbeziehung zwischen den einzelnen La-
            serkanälen durch eine interne Kopplung ergibt,

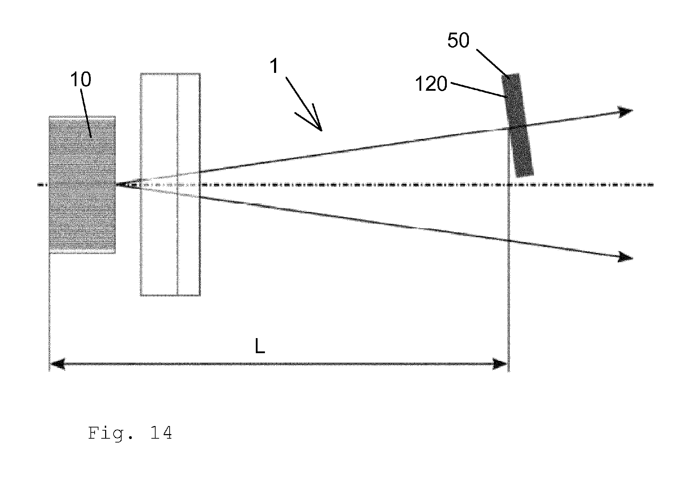

Figur 14    ein Ausführungsbeispiel für einen V-Resonator, bei dem durch Variation von Position
            und Winkel eines teildurchlässigen Spiegels
            festgelegt werden kann, unter welchem Winkel emittiertes Licht in den Laserchip zurückgekoppelt wird und welcher Mode bevorzugt
            angeregt wird,

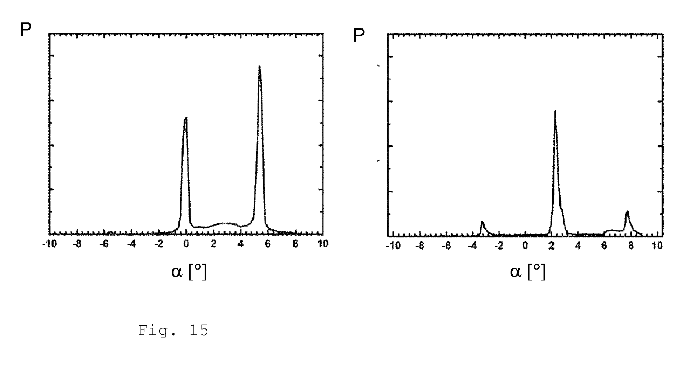

Figur 15    ein Ausführungsbeispiel für laterale Fernfelder eines Laserchips mit 419 gekrümmten
            Laserkanälen mit einem Abstand von jeweils
            6 μm, wobei der jeweils anschwingende Mode durch einen externen Resonator vorgegeben wird, wobei in der linken Darstellung
            von Figur 15 ein oszillierender Mode und in
            der rechten Darstellung von Figur 15 der In-
            Phase-Mode dargestellt ist und wobei jeweils die Intensität P über dem lateralen
            Fernfeldwinkel α dargestellt ist,

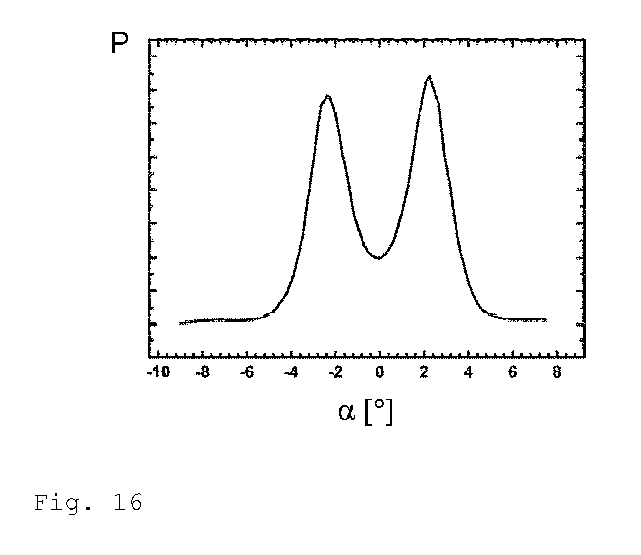

Figur 16    beispielhaft laterale Fernfelder eines Laserchips mit 438 geraden Laserkanälen, bei
            dem ohne einen externen Resonator der oszillierende Mode anschwingt,

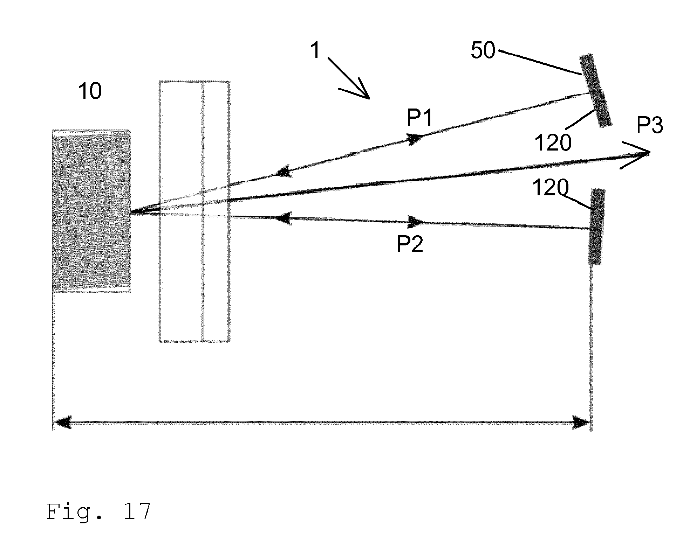

Figur 17    ein besonders bevorzugtes Ausführungsbeispiel für einen Laser, bei dem eine Anregung
            des In-Phase-Modes mit einem Fernfeld wie
            in Figur 15 rechts gezeigt erfolgt, indem die
            beiden äußeren Nebenkeulen des In-Phase-
            Modes zurückgekoppelt werden und die
            Hauptkeule des In-Phase-Modes ausgekoppelt wird und

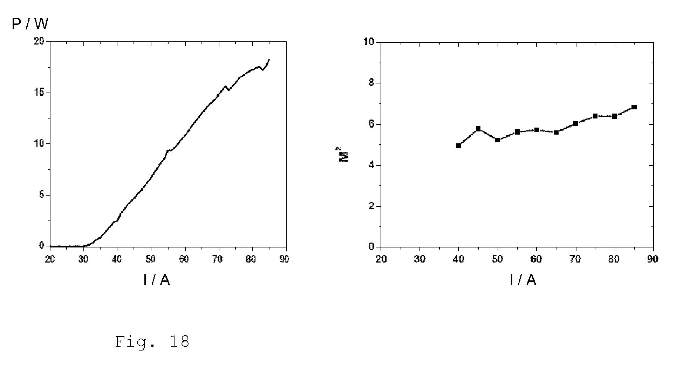

Figur 18    ein Ausführungsbeispiel für die Ausgangsleistung-Strom-Kennlinie (P-I-Kennlinie) der
            Hauptemissionskeule eines 5 mm breiten
            Laserchips mit 419 gekrümmten Laserkanälen mit einem Abstand von je 6 μm (linke Darstellung in Figur 18) und die zugehörigen M$^2$-Werte (rechte Darstellung in Figur 18).

In den Figuren werden der Übersicht halber für identische oder vergleichbare Komponenten stets dieselben Bezugszeichen verwendet.

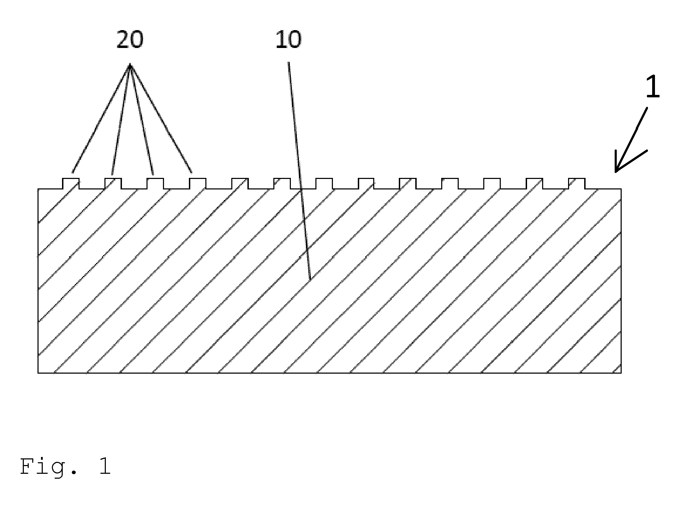

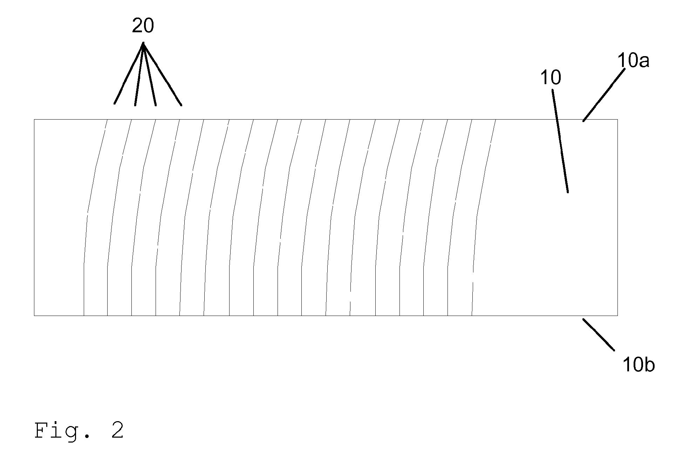

Die Figuren 1 und 2 zeigen einen Laser 1 mit einem Laserchip 10 in einem Schnitt entlang der Breite des Laserchips 10. Es ist eine Vielzahl an nebeneinander liegenden aktiven Laserkanälen 20 zu erkennen.

Der Laserchip 10 besteht vorzugsweise aus einem Halbleitermaterial, welches durch das Design der aktiven Bereiche eine effektive elektro-optische Umwandlung ermöglicht. Dieses ist z. B. mit einem Laserchip 10 aus GaAs möglich, dessen aktive Bereiche z. B. aus verschiedenen Schichten aus AlGaAs, InGaAs oder InAlGaAs gebildet werden. Die aktiven Laserkanäle 20 können durch Rippenwellenleiter gebildet werden, welche in die Chipoberfläche geätzt werden.

Die Rippen bzw. Rippenwellenleiter können Dimensionen im Bereich von einigen μm besitzen und der Abstand der Rippenwellenleiter zueinander kann wenige μm, aber auch deutlich mehr betragen. Die Figur 1 zeigt ein Beispiel, bei dem die einzelnen aktiven Laserkanäle 20 gleiche Abstände zueinander besitzen. Es ist aber auch möglich, dass zwischen den aktiven Laserkanälen 20 unterschiedliche Abstände realisiert sind oder auch Gruppen von aktiven Laserkanälen 20 existieren, die jeweils gleiche Abstände besitzen. Darüber hinaus können die aktiven Laserkanäle auch durch andere technische Strukturierungen der aktiven Halbleiterbereiche unter der Oberfläche des Laserchips erzeugt werden, wobei dann die Oberfläche des Laserchips weitgehend eben ist.

Die Figur 2 zeigt eine Aufsicht auf den Laserchip 10 gemäß Figur 1. Die vordere Kante bildet die Vorderfacette 10a des Laserchips 10, durch die die Strahlung austritt. Die hintere Kante bildet die Rückseiten-Facette bzw. Rückfacette 10b, welche im Allgemeinen hoch verspiegelt ist und aus der üblicherweise nur geringe oder keine Strahlung austritt. Man erkennt, dass die aktiven Laserkanäle 20 an der Rückseiten-Facette 10b jeweils einen rechten Winkel mit der Rückseiten-Facette 10b bilden. Dadurch wird eine optimale Reflexion der Strahlung und Rückkopplung in den jeweiligen aktiven Laserkanal erreicht.

An der Vorderfacette 10a besitzen die aktiven Laserkanäle 20 einen Winkel zu der Vorderfacette 10a, der von dem rechten Winkel abweicht. Durch diese Abweichung des Winkels kann die optische Rückkopplung der Strahlung in den jeweiligen aktiven Laserkanal durch die Reflexion an der Facette stark reduziert werden. Die Strahlung wird nach der Reflexion nicht mehr in den aktiven Laserkanal zurückgekoppelt, da sich der Winkel der reflektierten Strahlung deutlich von dem Winkel des jeweiligen aktiven Laserkanals unterscheidet. Die unterschiedlichen Winkel des aktiven Laserkanals an der Rückfacette 10b und der Vorderfacette 10a werden durch eine Krümmung der aktiven Laserkanäle 20 erreicht.

Die Figur 2 zeigt eine Ausgestaltung der aktiven Laserkanäle 20, bei der die parallel liegenden aktiven Laserkanäle alle eine kontinuierliche Krümmung über die gesamte Länge der Laserkanäle aufweisen.

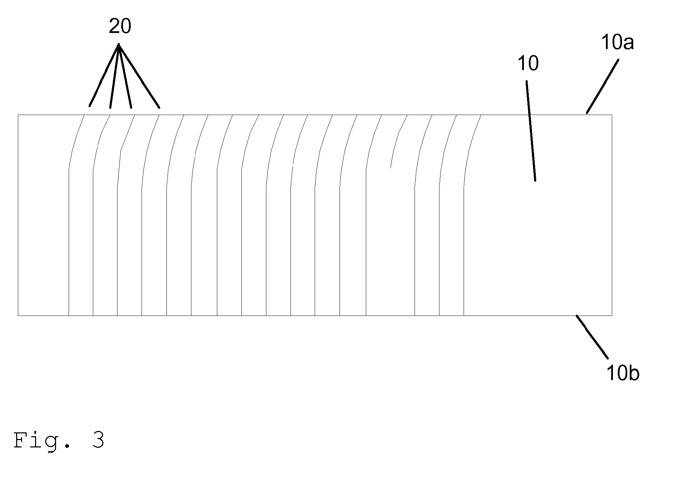

Figur 3 zeigt eine andere Ausgestaltung, bei der die aktiven Laserkanäle 20 von der Rückfacette 10b erst senkrecht und gerade verlaufen und dann erst in der Nähe der Vorderfacette 10a eine Krümmung aufweisen. Die aktiven Laserkanäle 20 besitzen also gerade als auch gekrümmte Kanalbereiche.

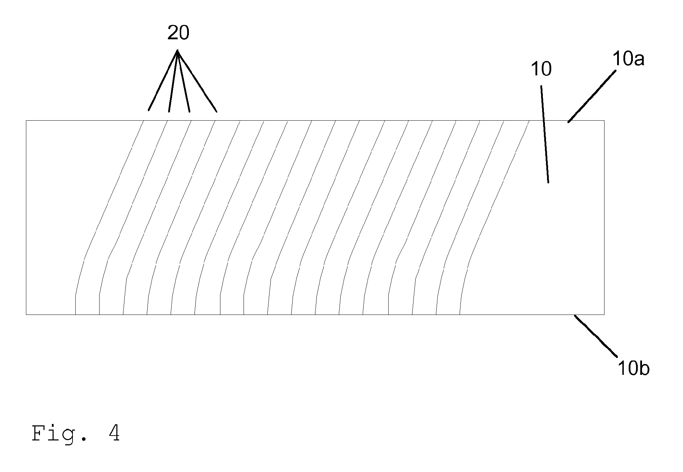

Die Figur 4 zeigt eine Ausgestaltung, bei der die aktiven Laserkanäle 20 senkrecht auf der Rückfacette 10b stehen und dort mit einer Krümmung beginnen. Danach verlaufen die aktiven Laserkanäle 20 aber in gerader Linie bis an die Vorderfacette, 10a, wo sie einen Winkel ungleich dem rechten Winkel zur Vorderfacette besitzen.

Die Ausgestaltungen gemäß den Figuren 2 bis 4 zeigen exemplarisch einige vorteilhafte Designs, bei denen die aktiven Laserkanäle 20 auf einem Laserchip 10 gleich gestaltet sind. Alternativ können die aktiven Laserkanäle 20 auf dem Laserchip 10 auch voneinander unterschiedliche Formen annehmen. Weiterhin müssen sie nicht gleiche Abstände besitzen und können in Gruppen angeordnet sein.

Durch enge Abstände der aktiven Laserkanäle 20 können die Strahlungsfelder der einzelnen aktiven Laserkanäle 20 auf dem Laserchip 10 in Wechselwirkung treten, und es können sich z. B. feste Phasenbeziehungen zwischen den Strahlungsfeldern der einzelnen aktiven Laserkanäle 20 auf dem Laserchip 10 herausbilden. Dadurch entstehen übergeordnete Strahlungsmoden, welche sowohl zu einer Reduzierung der Gesamtzahl der abgestrahlten Moden führen als auch zu einer Reduzierung des Raumbereiches (Winkelbereiches), in den abgestrahlt wird. Die Laserkanäle 20 können jedoch auch so weit auseinander liegen, dass die Kopplung der einzelnen Laserkanäle nur durch einen externen Resonator erreicht wird.

Weiterhin kann durch die Winkelstellung der aktiven Laserkanäle 20 an der Vorderfacette 10a die Rückreflexion sehr effektiv unterdrückt werden. Daher eignet sich diese Konfiguration besonders gut für eine Anordnung, bei der ein externer Resonator zur Bildung des Lasers 1 eingesetzt wird.

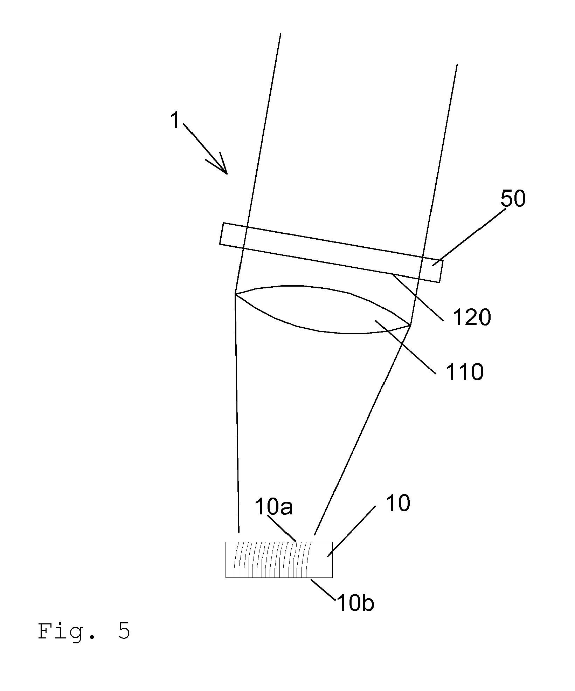

Die Figur 5 zeigt exemplarisch einen Laser 1 mit einem Laserchip 10 und einem externen Resonator 50. Die Strahlung, welche aus der Vorderfacette 10a des Laserchips 10 austritt wird, mit einer Linse 110 kollimiert. Ein Resonatorspiegel 120 eines externen Resonators 50 reflektiert den von der Linse 110 kollimierten Strahl, der durch die Linse 110 wieder in den Laserchip 10 zurückgekoppelt wird.

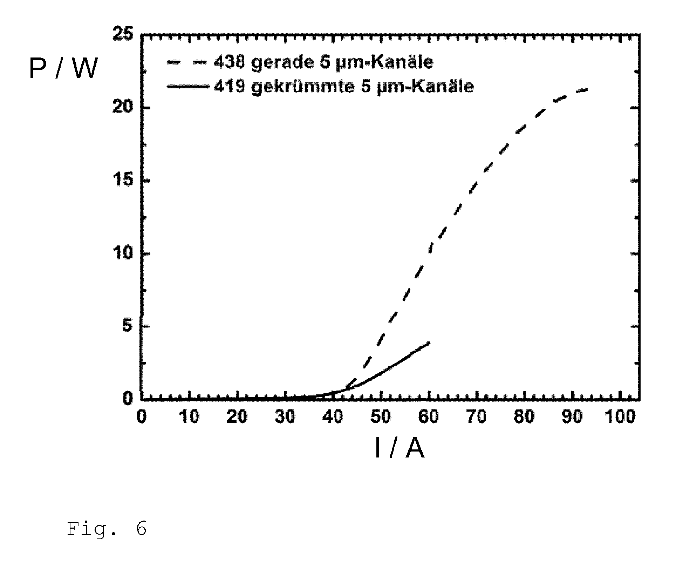

Durch das Einführen der Krümmung der Laserkanäle 20, wie sie oben im Zusammenhang mit den Figuren 2 bis 4 beispielhaft erläutert wurde, kann erreicht werden, dass die Laserkanäle 20 die Rückfacette 10b unter einem Winkel von 90° und die Frontfacette 10a unter einem Winkel ungleich 90° treffen. Somit kann die Reflektivität der Frontfacette 10a gezielt gesenkt werden unter Beibehaltung einer hohen Reflektivität der Rückfacette 10b. Dies soll beispielhaft anhand der Figur 6 erläutert werden:

Die Figur 6 zeigt gemessene Ausgangsleistung(P)-Strom(I)-Kennlinien zweier 5 mm breiter Laserchips 10 mit 438 geraden bzw. 419 gekrümmten Laserkanälen 20 mit antireflektierender Frontfacettenbeschichtung. Während der Laserchip 10 mit den geraden Laserkanälen 20 trotz antireflektierender Beschichtung ab einem Strom von etwa 42 A Lasertätigkeit aufweist (zu erkennen am linearen Anstieg der Leistung mit dem Strom), zeigt der Laserchip 10 mit gekrümmten Laserkanälen 20 nur einen schwachen Anstieg der Ausgangsleistung mit steigendem Strom, hier findet kein Lasing statt.

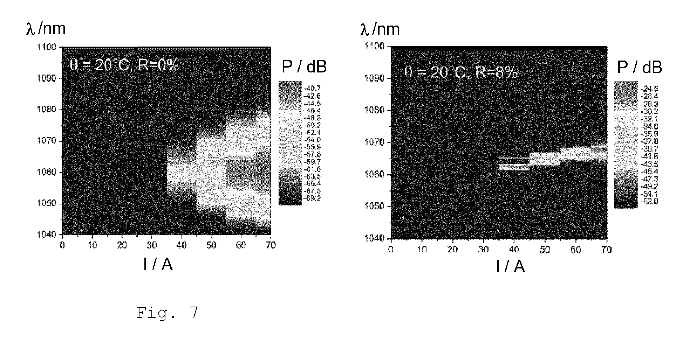

Die linke Seite von Figur 7 zeigt Spektren des Laserchips mit 419 gekrümmten Streifen als Funktion des Pumpstroms. Die große Breite des Spektrums sowie die geringe Leistung verdeutlichen, dass hier keine Lasertätigkeit stattfindet. Zum Vergleich sind auf der rechten Seite von Figur 7 stromabhängige Spektren desselben Laserchips mit externen Resonator abgebildet. Durch die Rückkopplung aufgrund des externen Resonators kommt es hier zum Lasing, wodurch sich die Breite des Spektrums deutlich verringert, wie es für Halbleiterlaser typisch ist.

Durch die zur Facettennormalen gekippte Lichtemission (Winkel ungleich 90°) an der Vorderfacette ist es außerdem möglich, die Intensität zwischen den Emissionskeulen der auftretenden Supermoden umzuverteilen. Die Intensitätsverteilung eines Modes im Fernfeld wird bestimmt durch das Produkt der Emission aller Laserkanäle (die einzelnen Keulen des Supermodes, deren Position durch den Kanalabstand der Laserkanäle gegeben ist) und der Emission jedes einzelnen Laserkanals, wie sie ohne Kopplung gegeben wäre (siehe Figur 8).

Die Figur 8 zeigt die Entstehung des Fernfeldes eines Modes bei gekoppelten Laserkanälen. Die Positionen der möglichen Emissionskeulen sind durch den Abstand der Laserkanäle gegeben (durchgezogene Linie); die Intensität in diesen Keulen wird durch die Emission der einzelnen Laserkanäle bestimmt (gestrichelte Linie).

Durch eine Geometrie der Laserkanäle ähnlich der in Figur 9 gezeigten kann man nun den Winkel der Emission der einzelnen Laserkanäle variieren und damit die Intensität in den möglichen Emissionskeulen verändern. Die Figur 10 zeigt Modellierungsergebnisse für das laterale Fernfeld für zwei unterschiedliche Laserchips:

Links ist in der Figur 10 beispielhaft ein Laserchip mit geraden Laserkanälen gezeigt. Beide Hauptemissionskeulen sind gleich stark.

Rechts ist in der Figur 10 beispielhaft ein Laserchip mit nahe der Frontfacette gekrümmten Laserkanälen gezeigt; die Intensitätsverteilung zwischen den Keulen ist hier entsprechend dem Emissionswinkel der Laserkanäle seitlich verschoben. Beim Laserchip mit gekrümmten Laserkanälen zeigt sich also aufgrund der gekippten Emission eine Umverteilung der Intensität zwischen den Emissionskeulen. Diese kann durch geeignete Wahl der Krümmung so gewählt werden, dass z. B. die Verluste bei einer Kopplung mit einem externen Resonator minimiert werden können oder andere Resonatorgeometrien ermöglicht werden.

In Laserchips mit mehreren Laserkanälen, bei denen die einzelnen Laserkanäle nah genug nebeneinander liegen, tritt bereits innerhalb des Laserchips Kopplung auf. Bei gerade angeordneten Laserkanälen mit geringem Abstand zeigt sich dabei ein oszillierender Mode, bei dem jeweils benachbarte Laserkanäle einen Phasenunterschied von $\pi$ aufweisen und eine Intensität von Null zwischen den einzelnen Laserkanälen auftritt. Da die Bereiche zwischen den einzelnen Laserkanälen nicht mit Strom gepumpt werden und in diesen somit Absorption auftritt, weist der oszillierende Mode demnach von allen Moden die geringsten Verluste innerhalb des Laserchips auf. Dieser Mode schwingt daher ohne externen Resonator bevorzugt an und lässt sich im externen Resonator am leichtesten fördern, was bei der gewollten Förderung eines anderen Modes hinderlich sein kann.

Durch Einführung einer Krümmung der Laserkanäle kann die Phasenbeziehung zwischen benachbarten Laserkanälen manipuliert werden. Aufgrund der Krümmung sind die Wegstrecken des Lichts in den einzelnen Laserkanälen unterschiedlich lang, wodurch sich die Phasenbeziehung zwischen den Laserkanälen mit dem Ort ändert. Die Figur 11 zeigt dies exemplarisch für drei Laserkanäle. Hier ist die Krümmung so gewählt, dass die Wegdifferenz benachbarter Laserkanäle $(2n+1)$-mal die Hälfte der Wellenlänge beträgt (n = 1, 2, 3, ...). Dies führt dazu, dass im unteren Teil eine Phasendifferenz von $\pi$ vorliegt, im oberen Teil ist die Differenz 0.

Dieser Sachverhalt kann z. B. genutzt werden, um im Inneren eines Laserchips mit schon intern koppelnden Laserkanälen auf einer geraden langen Strecke eine Phasenbeziehung von $\pi$ mit geringsten Verlusten zu erzielen und trotzdem an der Auskoppelfacette eine beliebige andere Phasenbeziehung zwischen benachbarten Laserkanälen zu erreichen und damit die Form des Fernfeldes zu manipulieren.

In der Figur 12 ist dieser Sachverhalt beispielhaft für einen Phasenunterschied von Null an der Auskoppelfacette dargestellt. Die Figur 12 zeigt die Änderung der Phasenbeziehung benachbarter Laserkanäle derart, dass an der Auskoppelfacette (oben) eine Phasenbeziehung von Null zwischen den benachbarten Laserkanälen vorliegt, während sie auf einer langen geraden Strecke im Chipinneren π beträgt. In der Figur 12 links ist die Emission unter einem zur Facettennormalen gekippten Winkel gezeigt. In der Mitte der Figur 12 ist die Emission senkrecht zur Vorderfacette durch Einführen eine S-Krümmung nahe der Vorderfacette gezeigt. Die Figur 12 zeigt rechts die Emission senkrecht zur Vorderfacette durch Einführen eine S-Krümmung mit mittig liegender gerader Strecke.

Neben der oben beschriebenen Ausnutzung der Krümmung zur Einstellung des Phasenunterschieds benachbarter Laserkanäle und der Intensitätsverteilung zwischen den unterschiedlichen Emissionskeulen ist es mittels Krümmungen auch möglich, die interne Kopplung und damit eine feste Phasenbeziehung zwischen benachbarten Laserkanälen gezielt zu verhindern. Dies resultiert darin, dass kein bestimmter Mode durch chipinterne Kopplung bevorzugt wird und die Auswahl des anschwingenden Modes nur durch den externen Resonator bestimmt werden kann. Dies kann z. B. durch eine Form der Laserkanäle (wie in Figur 13 gezeigt) erreicht werden. Hier ist der mittlere Teil der Laserkanäle über eine lange Strecke von 2 mm leicht gekrümmt, wodurch sich die Phasenbeziehung benachbarter Laserkanäle kontinuierlich verschiebt und sich somit keine durch interne Kopplung entstehende feste Phasenbeziehung zwischen den Laserkanälen ausbilden kann.

In erfinderseitig durchgeführten Experimenten an 5 mm breiten Laserchips 10 mit 419 gekrümmten Laserkanälen mit einem Abstand von je 6 μm zeigte sich, dass in einem V-Resonator 50 (vgl. Figur 14) sowohl der oszillierende Mode mit zwei Emissionskeulen als auch der In-Phase-Mode mit einer Haupt- und zwei Seitenkeulen problemlos angeregt werden können, je nach Spiegelstellung des Resonatorspiegels 120 des Resonators 50. Da durch interne Kopplung kein Mode bevorzugt wird, konnte die relative Phasenlage der einzelnen Laserkanäle von außen erfolgreich aufgeprägt werden. Die Länge L des Lasers 1 beträgt beispielsweise 800 mm.

Die Figur 15 zeigt die gemessenen lateralen Fernfelder des Laserchips 10 im externen Resonator 50 bei der Anordnung gemäß Figur 14 für den beispielhaften Fall eines Laserchips mit 419 gekrümmten Laserkanälen mit einem Abstand von jeweils 6 μm. Der jeweils anschwingende Mode wurde durch den externen Resonator 50 vorgegeben. Die Darstellung links zeigt den oszillierenden Mode und die Darstellung rechts den In-Phase-Mode. Aufgrund der Krümmung der Laserkanäle sind die Fernfelder zusätzlich lateral verschoben.

Vergleichende Messungen mit einem 5 mm breiten Laserchip mit 438 geraden Laserkanälen mit einem Abstand von jeweils 6 μm zeigen, dass ohne externen Resonator bevorzugt der oszillierende Mode anschwingt. Die Figur 16 zeigt beispielhaft das laterale Fernfeld des oszillierenden Modes im Betrieb ohne externen Resonator. Man sieht die lateralen Fernfelder eines Laserchips mit 438 geraden Laserkanälen.

Die Möglichkeit, auch bei geringem Abstand der Laserkanäle im Laserchip andere Moden als den oszillierenden Mode stabil anregen zu können, eröffnet neue Möglichkeiten für das Design des externen Resonators. Beim oszillierenden Mode hat man immer mindestens zwei Emissionskeulen, die für Anwendungen außerhalb des Resonators wieder vereinigt werden müssen. Bei Anregung des In-Phase-Modes (wie in Figur 15 rechts gezeigt) kann man hingegen die beiden Nebenkeulen zur externen Kopplung nutzen, wodurch sich nur eine einzige Emissionskeule hinter dem Resonator bilden lässt. Ein solcher Aufbau ist exemplarisch in Figur 17 dargestellt.

Die Figur 17 zeigt ein weiteres Ausführungsbeispiel für einen Laser 1 mit einem Laserchip 10 und einem externen Resonator 50. Bei diesem Laser 1 erfolgt die Anregung des In-Phase-Modes mit einem Fernfeld, wie es in Figur 15 rechts gezeigt ist. Die beiden äußeren Nebenkeulen P1 und P2 werden mittels zweier symmetrisch um die Hauptstrahlkeule P3 angeordneter Resonatorspiegel 120 des Resonators 50 zurückgekoppelt, die Hauptstrahlkeule P3 wird ausgekoppelt.

Bei dem Laser 1 gemäß Figur 17 konnte der In-Phase-Mode eines 5 mm breiten Laserchips mit 419 gekrümmten Laserkanälen mit einem Abstand von je 6 μm mittels des Resonators 50 angeregt und eine Ausgangsleistung der Hauptemissionskeule von 18 W erzielt werden (vgl. Figur 18 links). Die Strahlqualität war bis zu hohen Strömen von 85 A mit einem $M^2$-Wert von unter 7 exzellent (vgl. Figur 18 rechts).

Zum Vergleich: Der $M^2$-Wert eines 5 mm breiten Laserchips mit 438 geraden Laserkanälen mit einem Abstand von je 6 μm ohne externen Resonator zeigte einen hohen $M^2$-Wert von 45.

Die dimensionslose Beugungsmaßzahl $M^2$ ist ein Maß für die Strahlqualität eines (Laser-)strahls, die nach

$$M^2 \ = \ d_0 \ \Theta \ \pi \ / \ 4\lambda$$

vom Strahldurchmesser $d_0$, der Strahldivergenz $\Theta$ und der Wellenlänge $\lambda$ abhängt. Beugungsbegrenzte ideale Gaußstrahlen zeigen ein minimales $M^2$ von 1, während reale Laserstrahlen $M^2$-Werte größer 1 aufweisen. Je größer $M^2$ ist, umso schlechter ist der Strahl zu fokussieren, das heißt, umso größer ist der kleinste mögliche Fokusdurchmesser.

Bezugszeichenliste

| | |
|---|---|
| 1 | Laser |
| 10 | Laserchip |
| 10a | Vorderfacette / Frontfacette |
| 10b | Rückfacette |
| 20 | Laserkanal |
| 50 | Resonator |

110     Linse
120     Resonatorspiegel

I       Strom
L      Länge
P      Ausgangsleistung / Intensität
P1     Nebenkeule
P2     Nebenkeule
P3     Hauptstrahlkeule

$\alpha$      Fernfeldwinkel

$\lambda$      Wellenlänge

**Patentansprüche**

1. Laser (1) mit

 - einem Laserchip (10), der eine Mehrzahl aktiver Laserkanäle (20), eine Frontfacette (10a) zur Auskopplung der Laserstrahlung der Laserkanäle (20) und eine Rückfacette (10b) zur rückseitigen Reflexion der Laserstrahlung der Laserkanäle (20) in Richtung Frontfacette (10a) aufweist,
 - einem externen Resonator (50), der einen Teil der von dem Laserchip (10) an der Frontfacette (10a) austretenden Strahlung in den Laserchip (10) zurückkoppelt und durch die Rückkopplung die Strahlung der Laserkanäle (20) miteinander koppelt,
 - wobei zumindest einer der Laserkanäle (20) zumindest abschnittweise gekrümmt ist und - im Fernfeld - zusätzlich zu einer Hauptstrahlkeule (P3) von dem Laserchip (10) mindestens eine Nebenkeule (P1, P2) divergent abgestrahlt wird und
 - wobei der Resonator (50) mindestens eine der Nebenkeulen (P1, P2), die - im Fernfeld - neben einer Hauptstrahlkeule (P3) von dem Laserchip (10) divergent abgestrahlt wird, in Richtung Laserchip (10) reflektiert.

2. Laser (1) nach Anspruch 1,
 **dadurch gekennzeichnet, dass**

 - die Krümmung der Laserkanäle (20) derart ausgestaltet ist, dass ohne die Rückkopplung des Resonators (50) keine feste Phasenbeziehung zwischen benachbarten Laserkanälen (20) auftritt und kein Mode durch chipinterne Kopplung der Laserkanäle (20) bevorzugt wird, und
 - der im Laserchip (10) anschwingende Mode durch die Rückkopplung des Resonators (50) bestimmt wird.

3. Laser (1) nach einem der voranstehenden Ansprüche,
 **dadurch gekennzeichnet, dass**
 durch die Krümmung des oder der Laserkanäle (20) und die Kopplung der Laserkanäle (20) durch den Resonator (50) ein In-Phase-Mode mit - im Fernfeld - einer Hauptstrahlkeule (P3) und zwei neben der Hauptstrahlkeule (P3) divergent abstrahlenden Nebenkeulen (P1, P2) gebildet wird.

4. Laser (1) nach einem der voranstehenden Ansprüche,
 **dadurch gekennzeichnet, dass**
 der Resonator (50) derart ausgestaltet ist, dass er die Strahlung der Laserkanäle (20) derart optisch koppelt, dass im Laserchip (10) ein In-Phase-Mode anschwingt, der - im Fernfeld - die Hauptstrahlkeule (P3) und die divergent abstrahlenden Nebenkeulen (P1, P2) aufweist.

5. Laser (1) nach einem der voranstehenden Ansprüche,
 **dadurch gekennzeichnet, dass**
 die Hauptstrahlkeule (P3) aus dem Laser (1) ausgekoppelt wird.

6. Laser (1) nach einem der voranstehenden Ansprüche,
 **dadurch gekennzeichnet, dass**

 - durch einen oder mehrere Resonatorspiegel (120) des Resonators (50) zumindest eine der neben der Hauptstrahlkeule (P3) divergent abgestrahlten Nebenkeulen (P1, P2), vorzugsweise zwei unmittelbar benachbart neben der Hauptstrahlkeule (P3) divergent abgestrahlte Nebenkeulen (P1, P2), in Richtung Laserchip (10) reflektiert werden und
 - die Hauptstrahlkeule (P3) den oder die Resonatorspiegel (120) reflexionsfrei passiert.

7. Laser (1) nach einem der voranstehenden Ansprüche,
 **dadurch gekennzeichnet, dass**
 die Laserkanäle (20) voneinander abweichende Krümmungen aufweisen.

8. Laser (1) nach einem der voranstehenden Ansprüche,
 **dadurch gekennzeichnet, dass**
 durch die Krümmung des oder der Laserkanäle (20) und durch die Rückkopplung des Resonators (50) die Kopplung der Laserkanäle (20) derart eingestellt ist, dass die Phasenlage der an der Frontfacette (10a) austretenden Strahlung der einzelnen Laserkanäle (20) untereinander kleiner als 45°, vorzugsweise nahezu oder gleich Null, ist.

9. Laser (1) nach einem der voranstehenden Ansprüche 1 oder 3 bis 8,
**dadurch gekennzeichnet, dass**

   - durch eine chipinterne Kopplung der Laserkanäle (20) im Laserchip (10) zumindest auch ein In-Phase-Mode anschwingt, der - im Fernfeld - die Hauptstrahlkeule (P3) und die divergent abstrahlenden Nebenkeulen (P1, P2) aufweist, und
   - der im Laserchip (10) anschwingende Mode durch den externen Resonator (50) gefördert wird.

10. Laser (1) nach einem der voranstehenden Ansprüche,
**dadurch gekennzeichnet, dass**
auf dem Laserchip (10) durch die Krümmung der Laserkanäle (20) jeweils die Winkel der Laserkanäle (20) an der Frontfacette (10a) und der Rückfacette (10b) unterschiedlich sind und der Winkel zumindest einiger der Laserkanäle (20), vorzugsweise aller Laserkanäle (20), zur Frontfacette (10a) ungleich 90° ist.

11. Laser (1) nach einem der voranstehenden Ansprüche,
**dadurch gekennzeichnet, dass**
auf dem Laserchip (10) der Winkel zumindest einiger der Laserkanäle (20), vorzugsweise aller Laserkanäle (20), zur Rückfacette (10b) gleich 90° ist und die Rückfacette (10b) mit einer reflektierenden Beschichtung versehen ist.

12. Laser (1) nach einem der voranstehenden Ansprüche,
**dadurch gekennzeichnet, dass**
die Frontfacette (10a) des Laserchips (10) mit einer reflektionsvermindernden Beschichtung versehen ist.

13. Laser (1) nach einem der voranstehenden Ansprüche,
**dadurch gekennzeichnet, dass**
Teilbereiche der Laserkanäle (20) gekrümmt und Teilbereiche der Laserkanäle (20) geradlinig sind.

14. Laser (1) mit einem Laserchip (10), der eine Mehrzahl aktiver Laserkanäle (20), eine Frontfacette (10a) zur Auskopplung der Laserstrahlung der Laserkanäle (20) und eine Rückfacette (10b) zur rückseitigen Reflexion der Laserstrahlung der Laserkanäle (20) in Richtung Frontfacette (10a) aufweist,
**dadurch gekennzeichnet, dass**
zumindest einer der Laserkanäle (20) zumindest abschnittweise gekrümmt ist.

Fig. 1

Fig. 2

Fig. 3

Fig. 4

Fig. 5

Fig. 6

Fig. 7

Fig. 8

Fig. 9

P | **Laterales Fernfeld: gerade** Laserkanäle

P | **Laterales Fernfeld: gekrümmte** Laserkanäle

α [°]

α [°]

Fig. 10

Fig. 11

Fig. 12

Fig. 13

Fig. 14

Fig. 15

Fig. 16

Fig. 17

Fig. 18

Europäisches Patentamt

European Patent Office

Office européen des brevets

**EUROPÄISCHER RECHERCHENBERICHT**

Nummer der Anmeldung

EP 14 16 4759

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | ELARDE V C ET AL: "Curved Waveguide Array Diode Lasers for High-Brightness Applications", IEEE PHOTONICS TECHNOLOGY LETTERS, IEEE SERVICE CENTER, PISCATAWAY, NJ, US, Bd. 20, Nr. 13, 1. Juli 2008 (2008-07-01), Seiten 1085-1087, XP011215749, ISSN: 1041-1135 | 1,3-13 | INV. H01S5/14 H01S5/10 H01S5/40 |
| A | * Zusammenfassung; Abbildung 2 * <br> * das ganze Dokument * <br> ----- | 2 | |
| Y | TANG X ET AL: "MODE LOCKING OF INDIVIDUAL ARRAY MODES OF GAIN-GUIDED SINGLE-QUANTUM-WELL LASER ARRAY WITH AN EXTERNAL MIRROR", IEEE JOURNAL OF QUANTUM ELECTRONICS, IEEE SERVICE CENTER, PISCATAWAY, NJ, USA, Bd. 33, Nr. 5, 1. Mai 1997 (1997-05-01), Seiten 784-789, XP000690444, ISSN: 0018-9197, DOI: 10.1109/3.572152 | 1,3-13 | |
| A | * Zusammenfassung * <br> * das ganze Dokument * <br> ----- | 2 | **RECHERCHIERTE SACHGEBIETE (IPC)** <br><br> H01S |
| Y | WO 02/21651 A1 (PURUP ESKOFOT AS [DK]; PETERSEN PAUL MICHAEL [DK]) 14. März 2002 (2002-03-14) | 1,3-13 | |
| A | * Zusammenfassung; Abbildung 3 * <br> * das ganze Dokument * <br> ----- | 2 | |
| Y | WO 2005/124953 A1 (FORSKNINGSCT RISOE [DK]; PETERSEN PAUL MICHAEL [DK]; NIELSEN BIRGITTE) 29. Dezember 2005 (2005-12-29) | 1,3-13 | |
| A | * Abbildungen 2-5 * <br> * das ganze Dokument * <br> ----- | 2 | |
| Y | WO 01/33268 A1 (SPARKOLOR CORP [US]) 10. Mai 2001 (2001-05-10) * Abbildung 5 * <br> ----- | 1,3-13 | |

-/--

Der vorliegende Recherchenbericht wurde für alle Patentansprüche erstellt

| Recherchenort | Abschlußdatum der Recherche | Prüfer |
|---|---|---|
| München | 23. Juli 2014 | Lendroit, Stéphane |

Europäisches
Patentamt

European
Patent Office

Office européen
des brevets

**EUROPÄISCHER RECHERCHENBERICHT**

Nummer der Anmeldung

EP 14 16 4759

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 2011/310916 A1 (KIMOTO TATSUYA [JP] ET AL) 22. Dezember 2011 (2011-12-22) * Absatz [0038]; Abbildung 11 * ----- | 1,3-13 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 23. Juli 2014 | Lendroit, Stéphane |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 14 16 4759

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-07-2014

| Im Recherchenbericht angeführtes Patentdokument | Datum der Veröffentlichung | Mitglied(er) der Patentfamilie | | Datum der Veröffentlichung |
|---|---|---|---|---|
| WO 0221651 A1 | 14-03-2002 | AT | 363757 T | 15-06-2007 |
| | | AU | 8754501 A | 22-03-2002 |
| | | DK | 200001321 A | 06-03-2002 |
| | | EP | 1338063 A1 | 27-08-2003 |
| | | US | 2003165165 A1 | 04-09-2003 |
| | | WO | 0221651 A1 | 14-03-2002 |
| WO 2005124953 A1 | 29-12-2005 | AT | 400911 T | 15-07-2008 |
| | | DK | 1756922 T3 | 10-11-2008 |
| | | EP | 1756922 A1 | 28-02-2007 |
| | | US | 2007291812 A1 | 20-12-2007 |
| | | WO | 2005124953 A1 | 29-12-2005 |
| WO 0133268 A1 | 10-05-2001 | DE | 60022232 D1 | 29-09-2005 |
| | | DE | 60022232 T2 | 22-06-2006 |
| | | EP | 1282834 A2 | 12-02-2003 |
| | | JP | 4562339 B2 | 13-10-2010 |
| | | JP | 2003513328 A | 08-04-2003 |
| | | US | 6393185 B1 | 21-05-2002 |
| | | WO | 0133268 A1 | 10-05-2001 |
| US 2011310916 A1 | 22-12-2011 | CN | 102362400 A | 22-02-2012 |
| | | EP | 2413439 A1 | 01-02-2012 |
| | | US | 2011310916 A1 | 22-12-2011 |
| | | WO | 2010110152 A1 | 30-09-2010 |

EPO FORM P0461

Für nähere Einzelheiten zu diesem Anhang : siehe Amtsblatt des Europäischen Patentamts, Nr.12/82